# EUROPEAN PATENT SPECIFICATION

(11) **EP 0 407 791 B1**
(45) Date of publication and mention of the grant of the patent: **29.11.1995**
(21) Application number: 90111942.0
(22) Date of filing: 23.06.1990
(51) Int. Cl.: H04N 5/44

(54) **Television set**
Fernsehgerät
Appareil de télévision

(30) Priority: 07.07.1989 IT 6756089
(43) Date of publication of application: 16.01.1991
(73) Proprietor: EDICO S.r.l., I-00197 Roma (IT)
(72) Inventor: Farina, Attilio, I-10127 Torino (IT)
(74) Representative: Eisenführ, Speiser & Partner

(56) References cited:
- EP-A- 0 115 145
- EP-A- 0 219 703
- DE-A- 3 228 354
- GB-A- 1 268 822

## Description

Present invention refers to a use of apparatus comprising an image displaying device, a character generator and a control device.

It is known that all television sets comprise an image displaying device; many of the most recent sets also comprise a character generator, in order to be able to display also texts, e.g. in connection with a Televideo (Teletext) decoder.

All television sets comprise a control device too, with which the user can impart to the set suitable commands; in all recently producted television sets such a device comprises a keyboard having a plurality of keys, comprising for instance, beside other keys, ten keys bearing numbers from 0 to 9.

Furthermore it is known from DE-A-3228354 a television receiver provided with an image displaying device, a character generator, a memory, a control device and a logic circuit apt to the act commands giving by means of said control device for displaying on two said image displaying device instructions for the user memorized in said memory where said logic circuit as a consequence of the said commands reads in said memory and let display on two said image displaying device messages for controlling the television receiver. It is further known that the image displayed instructions forming a user guide with its help user can make adaptions which are interesting for him.

Modern television sets are complicated machines and it is known that often the user is not able to correctly handle them, at least the first times he gets in touch with them; this fact causes service calls, which are often unnecessary, because a better user education could avoid them. To show a few simple cases, a switch may be in the wrong position (typically the auxiliary loudspeaker switch, which disables the main loudspeaker), or the antenna cable may be misconnected, so that only one or two channels are received, and in bad condition; or the videorecorder operation, which could be missing, may have been inadvertently selected, so that the set is no more performing normal tuning operations, etc..

Therefore it is an object of the present invention to indicate how it is possible to implement an improved television receiver which allows the user to be informed of the corrective measures to be taken in the more usual misfunctioning cases due to insufficient education or improper use and it is a further object to avoid unnecessary calls to assistance services for television receiver.

To achieve the said object, the subject of present invention is a use of an apparatus comprising a guide to indicate reason of a misfunction of a television receiver, in cases where the set is not really defective, but only incorrectly set by the user, whereby the receiver is provided with the guide to the user for fixing the apparent defects, said guide being contained in the receiver in such a way that it cannot be separated from the receiver, said apparatus comprising
- a source of prestored messages,
- a control circuit,
- a command device producing, when activated, a first determined command or a second determined command to said control circuit,
- incorporating in said control circuit a logic circuit which reacts to said first determined command providing for
- reading from said source and displaying onto a screen coupled to the receiver a message in form of a question to the user ("The picture is available but the sound is missing?"), and/or of a correlated suggestion ("Check if the switch on the back of the set is in the left position"),
- said logic circuit reacting to said second determined command (0) providing for reading from said source and displaying onto the screen a next message, and
- the control circuit incorporates a testing unit which checks whether a command from the command device corresponds to the first or second determined command and which supports the display of a further message.

Further improvements and advantageous features are described in the subclaims.

The invention is based on the acknowledgement of the fact that many of the recent television sets are provided with a microprocessor in order to control several function of the set; and that it is relatively simple to use said microprocessor, programming it suitably, so that following a determined command given by the user through the control device (e.g. the remote control keyboard), the microprocessor will control the character generator to show on the display device a series of questions and the relevant answers (instructions for the user).

The questions and the answers shall of course have been memorized in advance in a memory, preferably of the ROM type, associated with said microprocessor.

The user command may be for instance a number, not associated to any channel, e.g. the number 00.

A television receiver already provided with a keyboard, a character generator, a microprocessor and a ROM memory is for instance known from the european patent application No 0 219 703, and it can constitute a valid starting point to implement the invention.

Other objects and advantages of the present invention will be clear from the detailed description which follows and from the attached drawings, which are supplied only as an explanatory and not limiting example.

In the drawings:
figure 1 shows a block diagram of the part of the receiver's circuit which is interesting for the implementation of the invention;
figure 2 shows schematically the blocks of the logical circuitry which allows the implementation of the principles of the invention.

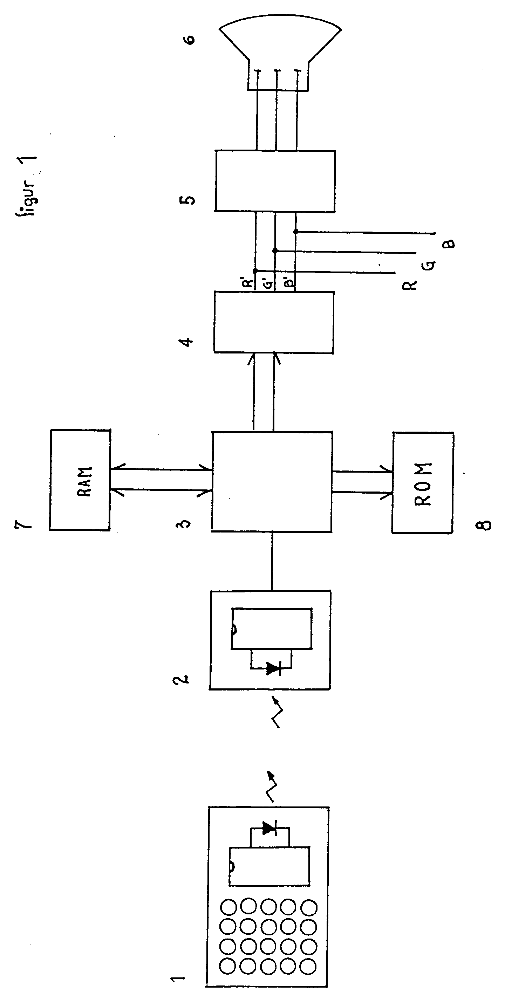

In figure 1, which schematically shows a block diagram of the part of the receiver's circuit which is interesting for the implementation of the invention, reference number 1 indicates an infrared remote control transmitter comprising a keyboard having a plurality of keys, among which there are at least 10 bearing the numbers from 0 to 9; reference number 2 indicates the relevant receiver, which provides for receiving and decoding the signals coming from device 1. Said devices 1 and 2 are of a known type, usually present on the majority of recent production television sets; therefore we will not give more details thereon; they can be easily got from customary component suppliers.

With reference number 3 there is indicated a control unit, which in the relevant example comprises a suitable microprocessor, e.g. of the 8 or 16 bits type usually found on television sets; for instance a Z80 or a MC68000.

Said microprocessor is connected to a couple of memories, a RAM type memory (indicated with reference number 7) and a ROM type memory (indicated with reference number 8); as known the RAM type memory is an alterable memory, i.e. a read/write one, while the ROM type memory is a fix or dead one, i.e. a read-only-memory.

With reference number 4 there is indicated a character generator, for instance a Teletext compatible generator, able to display on a television screen 24 lines of 40 characters each; a character generator of the said type is e.g. described in the cited european patent No 0 219 703.

Character generator 4 is connected to a color television video amplifying circuit (indicated with reference number 5), of a known type; said circuit 5 comprises three input terminals for receiving three color signals R (red), G (green) and B (blue); said terminals may be connected, besides to the character generator 4, also to three correspondent terminals pertaining to normal television receiver circuitry (in order to display a normal television picture).

Circuit 5 comprises three output terminals too, connected to a color display (indicated with reference number 6), which in the present case is a normal shadow mask picture tube.

The operation of the described circuit is as follows: when on the keyboard of the remote control transmitter 1 a predetermined combination is formed, for instance the combination of two zeroes (00), and said combination, suitably coded, is transmitted by means of the infrared rays to the receiveir 2, the latter decodes and sends it to the control unit 3.

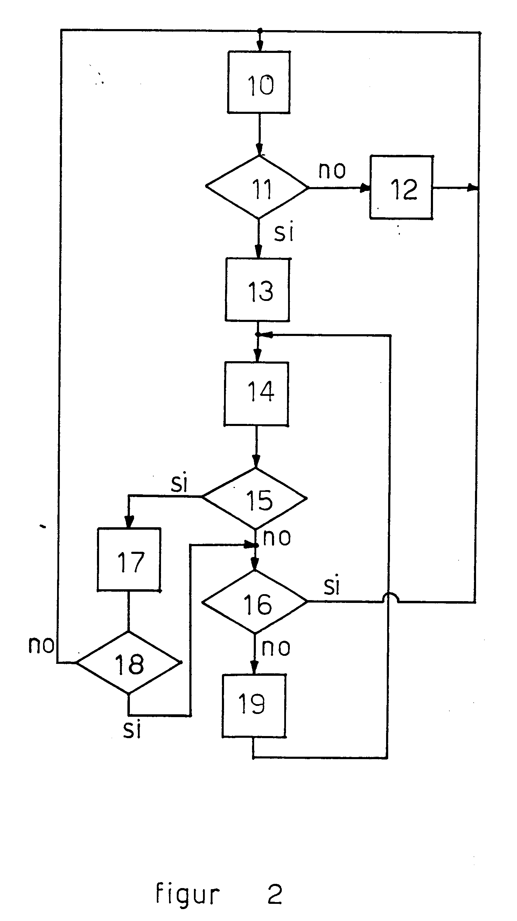

As will be explained in more detail later, referring to figure 2, control unit 3
- aknowledges the predetermined combination;
- provides for extracting from dead memory 8 a series of characters and sends them to generator 4, which in turn sends them, suitably coded, to amplifier 5, which in turn amplifies the signals and sends them to the picture tube 6.

The said series of characters is therefore displayed onto the television screen; colors may be utilized to highlight the most important words.

In the relevant example the series of characters consists of a few questions and answers; a question and the relevant answer are displayed onto the screen; to pass to the next question-answer the user must give, via device 1, a suitable command, e.g. a zero (0); and so on. As an alternative the up-down technique could be used, e.g. by means of the two usual "+" and "-" keys of any remote control device.

A few examples of possible questions and answers:
"The picture is available, but the sound is missing?
Check if the switch on the back of the set, labelled AL, is in the left position"
(case of the switch set for external loudspeaker);
"The picture is available only on some channels, and is very noisy?
Check if the antenna cable is properly inserted both in the set and in the wall sockets"
(case of the antenna cable not correctly inserted, e.g. after room cleaning...);
"The set does not react properly to tuning commands?
Press the key labelled T"
(case when the operation of videotape or other auxiliary device has been inadvertently selected);
"A good picture is no more obtainable?
Press the key labelled N"
(case when all color, brightness, etc commands have been mispositioned);
and so on.

In figure 2, where there are schematically shown the blocks of the logical circuitry which allows to implement the principles of the invention, reference number 10 indicates a logical block which represents the starting point of the relevant function; said block 10 corresponds to the case when the microprocessor is waiting for a signal coming from the control device 1.

At the moment when a signal arrives, the control passes to next block 11; block 11 is a test block, which checks if the received signal corresponds to the combination "00"; in the affirmative case (output SI) the control passes to block 13; in the negative case (output NO) the control passes to block 12.

Block 12 indicates schematically the execution of all functions correspondent to other possible control signals which the microprocessor is prepared to acknowledge; then block 12 returns control to first block 10.

Block 13 on the contrary provides for sending to memory 8 the proper address in order to read the desired messages and then passes the control to next block 14.

Block 14 provides for reading a character in the memory 8 and sending it to the generator 4; control then returns to block 15.

Block 15 is a test block, which checks if the read character corresponds to the predermined character, corresponding for instance to the character ("), indicating that the sentence is terminated; in the affirmative case (output SI) the control passes to block 17; in the negative case (output NO) the control passes to block 16.

Block 16 is a test block, which checks if the read character corresponds to the predermined character, corresponding for instance to the so called "end of form" character, indicating that the stored messages are over; in the affirmative case (output SI) the control goes back to block 10; in the negative case (output NO) the control passes to block 19.

Block 19 provides for incrementing the memory address and returns control to block 14.

Block 17, which is similar to block 10, waits for a new command from device 1; when it is received it passes control to block 18; block 18 is a test block, which checks if the received signal corresponds to the number "0"; in the affirmative case (output SI) the control passes to block 16; in the negative case (output NO) the control goes back to block 10.

The operation of the logical circuit shown in figure 1 is clear from the description given; it is also clear that it is a simplified circuit, for the sake of clearness and conciseness.

As it clearly results from the given description, the improved television set according to the invention allows the user to get useful hints to restore normal operation of the set in the most common cases of misuse or casual inconveniences, so avoiding the necessity of calling a technician, and saving time and money.

It is obvious that, subject to the invention principle, many variations to the manufacturing characteristics of improved television set described as an example are possible, without departing from the novelty principles inherent to the invention.

For instance it is not necessary that the set comprises a microprocessor, even if this is the simplest way to implement the invention; in fact it is well known that a microprocessor operates with a programmed logic, but that the same result may be obtained using an equivalent wired logic; in the specific case it is necessary to prepare a wired logic corresponding to the block diagram of figure 2, which is able to detect the key command (00) and, as a consequence, to provide for the displaying of a predetermined series of screens, containing the questions and the relevant answers or instructions.

## Claims

1. Use of an apparatus comprising a guide to indicate a reason of a misfunction of a television receiver, in cases where the set is not really defective, but only incorrectly set by the user, whereby the receiver is provided with the guide to the user for fixing the apparent defects, said guide being contained in the receiver in such a way that it cannot be separated from the receiver, said apparatus comprising
- a source of prestored messages,
- a control circuit,
- a command device producing, when activated, a first determined command (00) or a second determined command (0) to said control circuit,
- incorporating in said control circuit a logic circuit which reacts to said first determined command (00) providing for
- reading from said source and displaying onto a screen coupled to the receiver a message in form of a question to the user ("The picture is available but the sound is missing?"), and/or of a correlated suggestion ("Check if the switch on the back of the set is in the left position"),
- said logic circuit reacting to said second determined command (0) providing for reading from said source and displaying onto the screen a next message, and
- the control circuit incorporates a testing unit (11, 18) which checks whether a command from the command device corresponds to the first or second determined command and which supports the display of a further message.

2. Use of an apparatus according to claim 1 wherein said logical circuit (11) is implemented using a microprocessor (3).

3. Use of an apparatus according to claim 1 wherein said logical circuit (11) is implemented using a wired logic.

4. Use of an apparatus according to claim 1 wherein said control circuit (11) is implemented using a microprocessor (3).

5. Use of an apparatus according to claim 1 wherein said control circuit (11) is implemented using a wired logic.

6. Use of an apparatus according to claim 1 wherein said messages are stored in a read-only-memory (8).

7. Use of an apparatus according to claim 1 wherein a question and the relevant answer are displayed one at a time.

8. Use of an apparatus according to claim 1 wherein a display of a further message depends on activation of a predetermined key (0) in particular one of two predetermined keys (+,-), of said command device (1).

9. Use of an apparatus according to claim 1 wherein the logical circuit (11) incorporates the testing unit or its function.

## Patentansprüche

1. Verwendung eines Geräts, enthaltend eine Führung, um einen Grund für eine Fehlfunktion eines Fernsehempfängers in den Fällen anzuzeigen, bei denen der Empfänger nicht wirklich defekt ist, sondern vom Nutzer nur falsch eingestellt ist, wobei der Empfänger mit der Führung für den Nutzer zum Bestimmen der scheinbaren Fehler versehen ist und wobei die Führung in den Empfänger in der Weise eingebaut ist, daß sie nicht von dem Empfänger getrennt werden kann, und wobei das Gerät enthält:
- eine Quelle für vorgespeicherte Meldungen,
- eine Steuerschaltung,
- eine Befehlseinrichtung, die im aktivierten Zustand ein ersten vorgegebenen Befehl (00) oder einen zweiten vorgegebenen Befehl (0) an die Steuerschaltung abgibt,
- wobei die Steuerschaltung eine Logikschaltung beinhaltet, welche auf den ersten vorgegebenen Befehl (00) reagiert, der zum Lesen einer Meldung aus der Quelle und zum Anzeigen dieser Meldung auf dem zu dem Empfänger gehörenden Bildschirm in Form einer Frage an den Nutzer ("Das Bild ist verfügbar, aber der Ton fehlt?"), und/oder eines hierzu gehörenden Vorschlags ("Prüfe, ob sich der Schalter an der Rückseite des Empfängers in seiner linken Position befindet") vorgesehen ist,
- wobei die Logikschaltung auf den zweiten vorgegebenen Befehl (0) reagiert, der zum Lesen einer folgenden Meldung aus der Quelle und zum Anzeigen dieser Meldung auf dem Bildschirm vorgesehen ist, und
- wobei die Steuerschaltung eine Testeinheit (11, 18) beinhaltet, welche überprüft, ob ein Befehl aus der Befehlseinrichtung dem ersten oder zweiten vorgegebenen Befehl entspricht und welche die Anzeige einer weiteren Meldung unterstützt.

2. Verwendung eines Geräts nach Anspruch 1,
wobei die Logikschaltung (11) unter Verwendung eines Mikroprozessors (3) realisiert ist.

3. Verwendung eines Geräts nach Anspruch 1,
wobei die Logikschaltung (11) unter Verwendung einer verdrahteten Logik realisiert ist.

4. Verwendung eines Geräts nach Anspruch 1,
wobei die Steuerschaltung (11) unter Verwendung eines Mikroprozessors (3) realisiert ist.

5. Verwendung eines Geräts nach Anspruch 1,
wobei die Steuerschaltung (11) unter Verwendung einer verdrahteten Logik realisiert ist.

6. Verwendung eines Geräts nach Anspruch 1,
wobei die Meldungen in einem Nur-Lese-Speicher (ROM-Speicher) (8) gespeichert sind.

7. Verwendung eines Geräts nach Anspruch 1,
wobei eine Frage und die Antwort darauf nacheinander angezeigt werden.

8. Verwendung eines Geräts nach Anspruch 1,
wobei eine Anzeige einer weiteren Meldung von der Betätigung einer vorgegebenen Taste (0), insbesondere einer von zwei vorgegebenen Tasten (+, -) der Befehlseinrichtung (1) abhängt.

9. Verwendung eines Geräts nach Anspruch 1,
wobei die Logikschaltung (11) die Testeinheit oder ihre Funktion beinhaltet.

## Revendications

1. Utilisation d'un dispositif comprenant un guide pour indiquer une raison d'un défaut de fonctionnement d'un récepteur de télévision, dans des cas où l'ensemble n'est pas réellement défectueux, mais seulement mal réglé par l'utilisateur, selon laquelle le récepteur est fourni avec le guide pour l'utilisateur pour déterminer les défauts apparents, ledit guide étant contenu dans le récepteur de telle manière qu'il ne peut être séparé du récepteur, ledit dispositif comprenant :
- une source de messages préenregistrés,
- un circuit de contrôle,
- un dispositif de commande produisant, quand il est activé, une première commande déterminée (00) ou une seconde commande déterminée (0) audit circuit de contrôle,
- l'incorporation dans ledit circuit de contrôle d'un circuit logique qui réagit à ladite première commande déterminée (00) par la lecture de ladite source et l'affichage sur un écran couplé au récepteur d'un message sous la forme d'une question à l'utilisateur (" L'image est disponible mais le son manque ? " ), et/ou d'une suggestion corrélée (" Vérifiez si le commutateur à l'arrière de l'ensemble est dans la position gauche "),
- ledit circuit logique réagissant à ladite seconde commande déterminée (O) par la lecture de ladite source et l'affichage sur l'écran d'un message suivant, et
- le circuit de contrôle incorporant une unité de test (11, 18) qui vérifie si une commande du dispositif de commande correspond à la première ou à la seconde commande déterminée et qui assure l'affichage d'un message supplémentaire.

2. Utilisation d'un dispositif selon la revendication 1, dans lequel ledit circuit logique (11) est mis en oeuvre par un microprocesseur (3).

3. Utilisation d'un dispositif selon la revendication 1, dans lequel ledit circuit logique (11) est réalisée en logique câblée.

4. Utilisation d'un dispositif selon la revendication 1, dans lequel ledit circuit de contrôle (11) est mis en oeuvre par un microprocesseur (3).

5. Utilisation d'un dispositif selon la revendication 1, dans lequel ledit circuit de contrôle (11) est réalisée en logique câblée.

6. Utilisation d'un dispositif selon la revendication 1, dans lequel lesdits messages sont sauvegardés dans une mémoire morte (8).

7. Utilisation d'un dispositif selon la revendication 1, dans lequel une question et la réponse appropriée sont affichées une à la fois.

8. Utilisation d'un dispositif selon la revendication 1, dans lequel un affichage d'un message supplémentaire dépend de l'actionnement d'une commande prédéterminée (0), en particulier une des deux commandes prédéterminées (+, -), dudit dispositif de commande (1).

9. Utilisation d'un dispositif selon la revendication 1, dans lequel le circuit logique (11) comprend l'unité de test ou sa fonction.
